# FASCICULE DE BREVET EUROPEEN

(11) **EP 1 265 356 B1**
(45) Date de publication et mention de la délivrance du brevet: **18.08.2010**
(21) Numéro de dépôt: 02077157.2
(22) Date de dépôt: 31.05.2002
(51) Int. Cl.: H03F 3/343

(54) **Amplificateur à faible impedance d'entrée**
Verstärker mit niedriger Eingangsimpedanz
Amplifier with low input impedance

(30) Priorité: 06.06.2001 FR 0107389
(43) Date de publication de la demande: 11.12.2002
(73) Titulaire: NXP B.V., 5656 AG Eindhoven (NL)
(72) Inventeur: Braz, Fabio c/o Société Civile S.P.I.D., 75008 Paris (FR); Leclerc, Patrick c/o Société Civile S.P.I.D., 75008 Paris (FR); Guiraud, Lionel c/o Société Civile S.P.I.D., 75008 Paris (FR)
(74) Mandataire: Schouten, Marcus Maria

(56) Documents cités:
- US-A- 5 444 361
- US-A- 5 498 953
- US-A- 5 825 167

## Description

La présente invention s'inscrit dans le domaine des amplificateurs, notamment des amplificateurs de courant (voir par exemple US 5 444 361). De tels amplificateurs sont avantageusement mis en oeuvre dans des matrices de commutation, qui sont des circuits ou des ensembles de circuits présentant N entrées de signal et P sorties de signal, et qui ont pour particularité que chacune des P sorties peut être, sur commande, connectée à chacune des N entrées.

Dans une telle matrice, des chemins de courant présentant des longueurs importantes doivent être utilisés pour relier les entrées aux sorties, lesdites longueurs étant d'autant plus grandes que le nombre des entrées et des sorties, et donc la complexité de la matrice considérée, sont importants. On choisira alors généralement d'utiliser des signaux de courants plutôt que des signaux de tension pour véhiculer des informations entre les entrées et les sorties de la matrice. En effet, la longueur des chemins de courant est telle qu'elle donne naissance à des pertes résistives et capacitives qui provoquent des chutes de tension non-négligeables par rapport à l'amplitude d'une composante alternative d'un signal de tension qui véhiculerait une information.

Les matrices de commutation étant couramment réalisées sous forme de circuits intégrés, les signaux de courant qui les traversent ont généralement une amplitude relativement faible, le plus souvent de l'ordre du microampère. Un tel signal de courant doit donc être amplifié afin de pouvoir être utilisé par des éléments extérieurs à la matrice. Cependant, chaque borne de sortie étant connectée à une multiplicité de chemins de courant présentant d'importantes résistances et capacités parasites, qui constituent une charge substantielle, vue depuis ladite borne de sortie, il est impératif qu'un amplificateur destiné à amplifier le signal de courant avant sa mise à disposition sur la borne de sortie présente une faible impédance d'entrée afin de minimiser les pertes de signal.

Par ailleurs, pour qu'un signal disponible sur une borne de sortie de la matrice puisse être utilement exploité par des éléments situés en aval de celle-ci, il est souhaitable de construire l'amplificateur de sorte qu'il présente un niveau de mode commun de sortie le plus faible possible, c'est-à-dire que la valeur du potentiel au repos de sa borne de sortie doit être le moins élevé possible. Ceci permettra de ménager la plus large plage de variation possible à une composante alternative du signal de sortie, représentative de l'information véhiculée par ledit signal, en limitant les risques de saturation d'étages d'entrée des éléments disposés en aval de la matrice.

L'invention a pour but de répondre à ces exigences en proposant un amplificateur tel que défini à la revendication 1.

Il sera démontré dans la suite de l'exposé que l'amplificateur selon l'invention présente une faible impédance d'entrée, particulièrement du fait de la connexion réalisée entre les bornes de transfert et de polarisation des premier et deuxième transistors d'entrée, respectivement.

Plusieurs solutions peuvent être envisagées pour prélever un signal de sortie depuis un amplificateur conforme à l'invention :

Dans une première configuration, l'amplificateur décrit ci-dessus inclut en outre un troisième transistor disposé en miroir de courant avec le deuxième transistor, la borne de transfert du troisième transistor formant une sortie de l'amplificateur.

Une telle configuration permet d'ajuster le gain de l'amplificateur par choix d'un rapport de dimensions entre les deuxième et troisième transistors.

Dans une deuxième configuration, l'amplificateur décrit plus haut inclut en outre un troisième transistor disposé en suiveur, dont la borne de transfert forme une sortie de l'amplificateur, et dont la borne de polarisation est reliée à la borne de transfert du deuxième transistor.

Une telle configuration permet d'ajuster le gain de l'amplificateur par choix des paramètres de polarisation du suiveur incorporant le troisième transistor.

La suite de l'exposé fera apparaître que, dans chacune des configurations décrites ci-dessus, aucun trajet de courant séparant la sortie d'une masse de l'amplificateur n'inclut plus d'un transistor, ce qui garantit un faible niveau de mode commun en sortie de l'amplificateur.

Un amplificateur conforme à la deuxième configuration inclura avantageusement une résistance insérée entre les premier et deuxième transistors.

Cette résistance génère une chute de tension qui permet une plus grande excursion du signal que le suiveur recevra sur son entrée, et autorise donc une plus grande plage de variation du signal de sortie que le suiveur est destiné à délivrer.

Dans la description qui précède, l'amplificateur présente une structure asymétrique, c'est-à-dire que son entrée et sa sortie sont destinées à recevoir et à délivrer des signaux asymétriques. Dans nombre d'applications, il est préférable d'utiliser des signaux différentiels et des structures symétriques, notamment dans le but d'éliminer des sources et vecteurs de bruit au moyen de compensation d'harmoniques parasites générés par des composants qui sont symétriques de part et d'autre des structures impliquées.

L'invention propose donc également un amplificateur tel que défini à la revendication 4 ayant une structure symétrique.

Un tel amplificateur est peu bruyant de part sa structure symétrique, et présente une impédance d'entrée du même ordre que celle de l'amplificateur de nature asymétrique décrit plus haut.

Une configuration comprenant des transistors disposés en miroirs de courant permet d'ajuster le gain de l'amplificateur par choix d'un rapport de dimensions entre ces transistors,.

Une configuration comprenant une paire différentielle de sortie permet d'ajuster le gain de l'amplificateur par choix des paramètres de polarisation de la paire différentielle de sortie.

La suite de l'exposé fera apparaître que, dans chacune de ces configurations, aucun trajet de courant séparant la sortie différentielle d'une masse de l'amplificateur n'inclut plus d'un transistor, ce qui garantit un faible niveau de mode commun en sortie de l'amplificateur.

Une configuration comprenant une paire différentielle de sortie comprend avantageusement des résistances générant des chutes de tension qui permettent une plus grande excursion du signal différentiel que la paire différentielle de sortie recevra sur ses entrées, et autorise donc une plus grande plage de variation du signal de sortie que ladite paire différentielle est destiné à délivrer.

On pourra en outre prévoir d'insérer une résistance supplémentaire afin d'arriver à un mode de réalisation telle que défmi à la revendication 5.

Cette résistance supplémentaire permet de dévier une partie du courant qui aurait parcouru les premiers transistors d'entrée en son absence, courant qui peut être important si les dimensions des deuxièmes transistors d'entrée sont grandes. Ceci permet de choisir des dimensions plus faibles pour les premiers transistors d'entrée, sans encourir de risque de les voir endommagés par de forts courants.

Ainsi qu'exposé précédemment, un amplificateur selon l'invention est particulièrement bien adapté à une utilisation au sein d'une matrice de commutation. L'invention concerne donc également un matrice de commutation présentant N entrées de signal et P sorties de signal, dans laquelle chacune des sorties de signal peut être connectée à chacune des entrées de signal via au moins un trajet de courant incluant au moins un amplificateur tel que décrit plus haut.

L'invention sera mieux comprise à l'aide de la description suivante, faite à titre d'exemple non-limitatif et en regard des dessins annexés, dans lesquels :
- La Fig. 1 est un schéma électrique décrivant une première configuration d'un amplificateur asymétrique selon l'invention,
- La Fig. 2 est un schéma électrique décrivant une deuxième configuration d'un amplificateur asymétrique selon l'invention,
- La Fig. 3 est un schéma électrique décrivant une première configuration d'un amplificateur symétrique selon l'invention,
- La Fig. 4 est un schéma électrique décrivant une deuxième configuration d'un amplificateur symétrique selon l'invention, et
- La Fig. 5 est un schéma fonctionnel partiel décrivant une matrice de commutation incorporant un amplificateur selon l'invention.

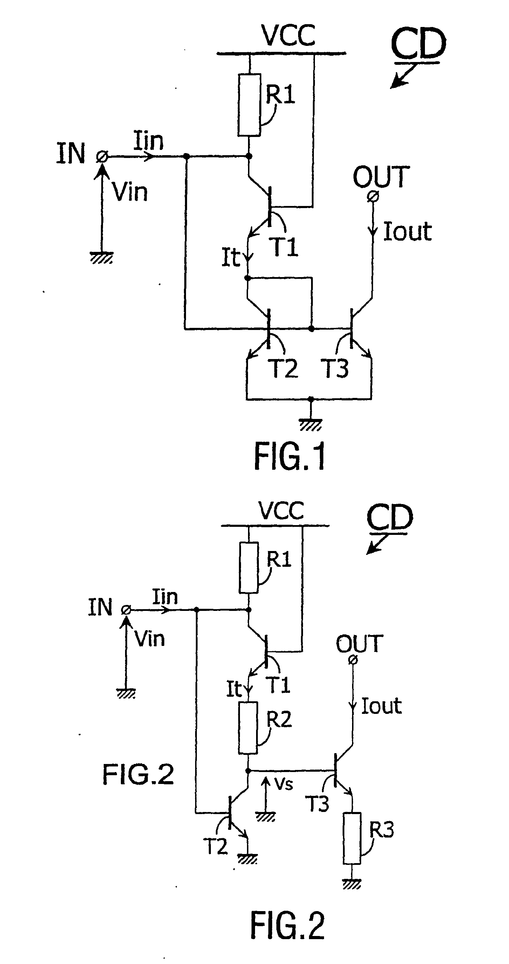

La Fig. 1 représente un amplificateur CD selon l'invention. Cet amplificateur CD inclut un premier et un deuxième transistor T1 et T2. Ces transistors sont ici de type bipolaire et sont donc munis de bases, collecteurs et émetteurs qui constituent respectivement des bornes de polarisation, de transfert et de référence. Les chemins de courant principaux des premier et deuxième transistors T1 et T2, constitués par leurs jonctions collecteur-émetteur, sont disposés en série entre une première et une deuxième borne d'alimentation, constituées ici par une source d'énergie VCC et une masse de l'amplificateur CD. L'amplificateur CD représenté ici inclut en outre une première résistance R1 insérée entre la première borne d'alimentation VCC et la borne de transfert du premier transistor T1, laquelle borne de transfert est reliée à la borne de polarisation du deuxième transistor T2 et forme une entrée de l'amplificateur CD, destinée à recevoir une tension d'entrée Vin et un courant d'entrée Iin. La borne de polarisation du premier transistor T1 est reliée à une borne de référence de potentiel, en l'occurrence la première borne d'alimentation VCC.

Il peut être aisément démontré, en recourant à des schémas équivalents en petits signaux alternatifs des premier et deuxième transistors T1 et T2, que l'amplificateur CD présente une impédance d'entrée Zin=Vin/Iin qui est, en première approximation, égale à R1/(1+gm0.R1), où gm0 est la transconductance des transistors T1 et T2, égale à It/Vt avec Vt/It=26mA/V... 27°C dans les technologies de fabrication courantes.

Ainsi, lorsque R1.gm0 est grand devant 1, ce qui est le cas dès que l'ordre de grandeur de la première résistance R1 dépasse l'Ohm, la valeur de l'impédance d'entrée Zin de l'amplificateur CD est voisine de 1/gm0=26mΩ.

La figure 1 représente une première configuration d'un amplificateur CD conforme à l'invention, destiné à produire un courant de sortie Iout prélevé au moyen d'un troisième transistor T3 disposé en miroir de courant avec le deuxième transistor T2, la borne de transfert du troisième transistor formant une sortie OUT de l'amplificateur CD.

Une telle configuration permet d'ajuster le gain de l'amplificateur CD par choix d'un rapport de dimensions entre les deuxième et troisième transistors T2 et T3. Ainsi, si le troisième transistor T3 est k fois plus grand que le deuxième transistor T2, on aura Iout=k.It où It est un courant destiné à traverser le deuxième transistor T2.

La figure 2 représente une deuxième configuration d'un amplificateur CD conforme à l'invention, destiné à produire un courant de sortie Iout prélevé au moyen d'un troisième transistor T3 disposé en suiveur, dont la borne de transfert forme une sortie OUT de l'amplificateur CD, et dont la borne de polarisation est reliée à la borne de transfert du deuxième transistor T2. Une deuxième résistance R2 est insérée entre les premier et deuxième transistors T1 et T2. Cette deuxième résistance R2 génère une chute de tension R2.It qui permet une plus grande excursion du signal Vs=VCC-(R1+R2).It que le suiveur recevra sur son entrée, et autorise donc une plus grande plage de variation du signal de sortie Iout que le suiveur est destiné à délivrer. Une telle configuration permet d'ajuster le gain de l'amplificateur CD par choix des paramètres de polarisation du suiveur incorporant le troisième transistor T3, par exemple par réglage de la valeur d'une troisième résistance R3 destinée à polariser ledit suiveur.

Il est à noter que, dans chacune des configurations décrites par les figures 1 et 2, aucun trajet de courant séparant la sortie OUT de la masse de l'amplificateur CD n'inclut plus d'un transistor, ce qui garantit un faible niveau de mode commun en sortie de l'amplificateur CD.

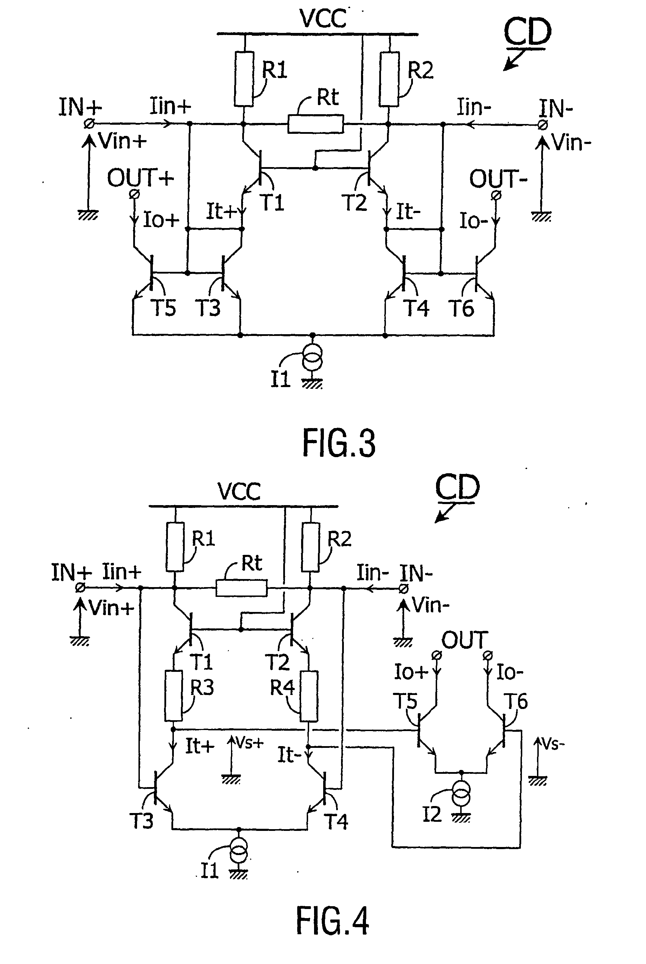

La figure 3 représente un amplificateur CD symétrique conforme à l'invention. Cet amplificateur CD inclut un premier, un deuxième, un troisième et un quatrième transistor T1, T2, T3 et T4. Ces transistors sont ici de type bipolaire et sont donc munis de bases, collecteurs et émetteurs qui constituent respectivement des bornes de polarisation, de transfert et de référence. Les chemins de courant principaux des premier et troisième transistors T1 et T3, d'une part, et des deuxième et quatrième transistors T2 et T4, d'autre part, constitués par leurs jonctions collecteur-émetteur, sont disposés en série entre une première et une deuxième borne d'alimentation, constituées ici par une source d'énergie VCC et une masse de l'amplificateur CD. Cet amplificateur CD inclut en outre une première et une deuxième résistance R1 et R2 respectivement insérées entre la première borne d'alimentation VCC et les bornes de transfert des premier et deuxième transistors T1 et T2, lesquelles bornes de transfert sont respectivement reliées aux bornes de polarisation des troisième et quatrième transistors T3 et T4 et forment une entrée différentielle (IN+, IN-) de l'amplificateur symétrique CD, les bornes de polarisation des premier et deuxième transistors T1 et T2 étant reliées ensemble à une borne de référence de potentiel, constituée ici par la première borne d'alimentation VCC, les troisième et quatrième transistors T3 et T4 formant ensemble une paire différentielle, polarisée ici par une première source de courant I1.

Cet amplificateur CD présente ainsi une structure symétrique, c'est-à-dire qu'il possède une entrée différentielle (IN+, IN-) et une sortie différentielle (OUT+, OUT-) respectivement destinées à recevoir et à délivrer des signaux symétriques (Iin+, Iin-) et (Io+, Io-). Une telle structure permet entre autres d'éliminer des sources et vecteurs de bruit au moyen de compensation d'harmoniques parasites générés par des composants qui sont symétriques de part et d'autre de la structure, selon une technique bien connue de l'homme du métier. L'impédance d'entrée Zin d'un tel amplificateur, qui met en jeu deux structures asymétriques telles celles décrites plus haut, qui apparaissent en série entre les deux bornes d'entrée IN+ et IN-, et des signaux d'entrée (Vin+, Vin-) et (Iin+, Iin-) d'amplitude double de ceux présentés dans la description des structures asymétriques, est du même ordre que celle propre aux dites structures asymétriques

La figure 3 représente une première configuration d'un amplificateur symétrique CD conforme à l'invention, destiné à produire un courant de sortie différentiel (Io+, Io-) prélevé au moyen d'un cinquième et d'un sixième transistor T5 et T6 respectivement disposés en miroirs de courant avec les troisième et quatrième transistors T3 et T4, les bornes de transfert des cinquième et sixième transistors T5 et T6 formant une sortie différentielle OUT de l'amplificateur CD. Une telle configuration permet d'ajuster le gain de l'amplificateur CD par choix d'un rapport de dimensions entre les troisième et cinquième transistors T3 et T5, d'une part, et les quatrième et sixième transistors T4 et T6, d'autre part.

La figure 4 représente une deuxième configuration d'un amplificateur symétrique CD conforme à l'invention, destiné à produire un courant de sortie différentiel (Io+, Io-) prélevé au moyen d'un cinquième et d'un sixième transistor T5 et T6 , formant ensemble une paire différentielle de sortie, dont les bornes de transfert forment une sortie différentielle OUT de l'amplificateur CD, et dont les bornes de polarisation sont reliées aux bornes de transfert des troisième et quatrième transistors T3 et T4. Une telle configuration permet d'ajuster le gain de l'amplificateur CD par choix des paramètres de polarisation de la paire différentielle de sortie (T5, T6), par exemple par réglage d'un courant débité par une deuxième source de courant I2 destinée à polariser ladite paire différentielle.

Des troisième et quatrième résistances R3 et R4 sont respectivement insérées entre les premier et troisième transistors T1, T3, d'une part, et les deuxième et quatrième transistors T2 et T4, d'autre part. Ces troisième et quatrième résistances R3 et R4 génèrent respectivement des chutes de tension R3.It+ et R4.It- qui permettent une plus grande excursion du signal différentiel (Vs+, Vs-) que la paire différentielle de sortie (T5, T6) recevra sur ses entrées, et autorise donc une plus grande plage de variation du signal de sortie (Io+, Io-) que ladite paire différentielle est destiné à délivrer.

On pourra en outre prévoir d'insérer une résistance supplémentaire Rt entre les bornes de transfert des premier et deuxième transistors T1 et T2.

Cette résistance Rt permet de dévier une partie du courant (It+, It-) qui aurait parcouru les premier et deuxième transistors T1 et T2 en son absence, courant qui peut être important si les dimensions des troisième et quatrième transistors T3 et T4 sont grandes. Ceci permet de choisir des dimensions plus faibles pour les premier et deuxième transistors T1 et T2, sans encourir de risque de les voir endommagés par de forts courants.

Il est à noter que, dans chacune des configurations décrites par les figures 3 et 4, aucun trajet de courant séparant la sortie OUT de la masse de l'amplificateur symétrique CD n'inclut plus d'un transistor, ce qui garantit un faible niveau de mode commun en sortie de l'amplificateur CD.

Par ailleurs, si dans les exemples décrits plus haut, les transistors employés sont tous de type bipolaire, il est parfaitement envisageable de leur substituer en tout ou partie des transistors de type MOS présentant des grilles, drains et sources qui formeront respectivement des bornes de polarisation, de transfert et de référence des transistors concernés.

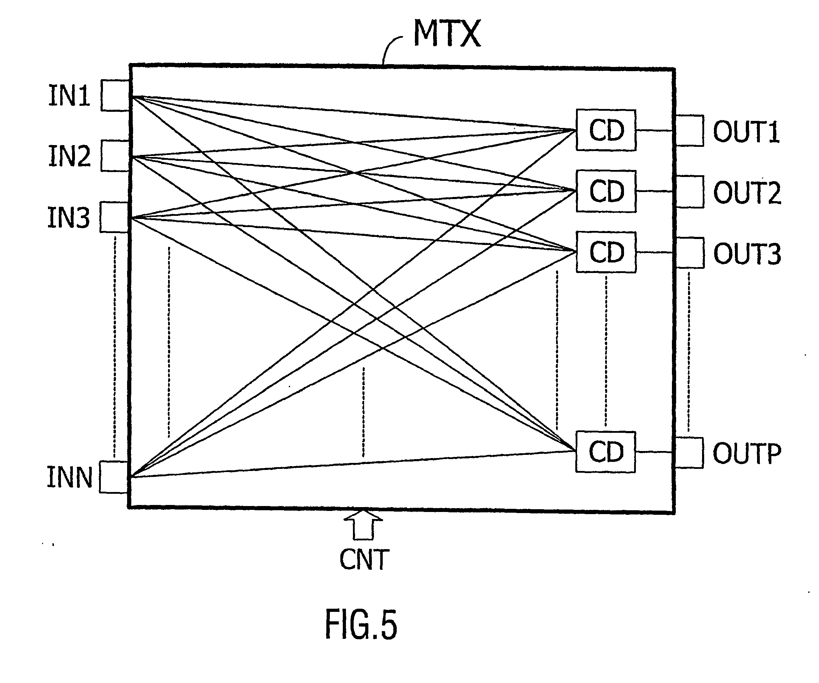

La figure 5 représente schématiquement une matrice de commutation MTX, présentant N entrées de signal (IN1...INN) et P sorties de signal (OUT1...OUTP), matrice dans laquelle chacune des sorties de signal OUTi (pour i=1 à P) peut être connectée à chacune des entrées de signal (IN1...INN) via au moins un trajet de courant incluant au moins un amplificateur CD tel que décrit plus haut. Une sélection des trajets de courant qui relient effectivement les entrées aux sorties de la matrice dans une configuration donnée est effectuée par choix d'une valeur d'un signal de contrôle CNT.

L'amplificateur CD conforme à l'invention amplifie, avant mise à disposition sur une borne de sortie OUTi (pour i=1 à P), un signal de courant provenant de l'une quelconque des entrées de signal INi (pour i=1 à N). Chaque borne de sortie OUTi (pour i=1 à P) étant reliée à une multitude de trajets de courant créant une forte charge, la faible impédance d'entrée de l'amplificateur CD conforme à l'invention permet une bonne restitution de l'information perçue sur la borne d'entrée INi à laquelle il est relié. Par ailleurs, le faible niveau de mode commun du signal de sortie de l'amplificateur CD permet de ménager la plus large plage de variation possible à une composante alternative du signal présent sur la borne de sortie OUTi (pour i=1 à P), en limitant les risques de saturation d'étages d'entrée d'éléments disposés en aval de la matrice MTX.

## Revendications

1. Amplificateur (CD) incluant plusieurs transistors, chacun muni d'une borne de polarisation, d'une borne de transfert et d'une borne de référence, l'amplificateur comprenant:
- une section d'entrée comprenant un premier et un deuxième transistor d'entrée (FIGS. 3, 4: T1, T3) disposés en série entre une première et une deuxième borne d'alimentation, la borne de transfert du premier transistor d'entrée (T1) formant une entrée (IN+) de l'amplificateur et étant reliée à la borne de polarisation du deuxième transistor d'entrée (T3) par un court-circuit et reliée à la première borne d'alimentation par une résistance (R1), la borne de polarisation du premier transistor d'entrée étant reliée à une borne de référence de potentiel (VCC),
- une section de sortie comprenant un transistor de sortie (T5) agencé pour produire un courant de sortie (Io+) qui est une copie d'un courant (It+) traversant le deuxième transistor d'entrée (T3).

2. Amplificateur selon la revendication 1, dans lequel le deuxième transistor d'entrée (FIG. 3 : T3) et le transistor de sortie (T5) forment un miroir de courant.

3. Amplificateur selon la revendication 1, incluant une résistance (R3) insérée entre la borne de référence du premier transistor d'entrée (FIG. 4 : T1) et la borne de transfert du deuxième transistor d'entrée (FIG. 4 : T3), la résistance provoquant une chute de tension reçue par le transistor de sortie (T5) à sa borne de polarisation, de sorte que le courant de sortie (Io+) varie en fonction de ladite chute de tension.

4. Amplificateur selon la revendication 1, l'amplificateur comprenant une section d'entrée complémentaire (FIG. 3, 4: T2, T4) ayant une structure similaire à la section d'entrée (FIG. 3, 4: T1, T3) définie à la revendication 1 et formant une paire avec celle-ci pour recevoir un signal d'entrée différentiel, la section de sortie comprenant une paire de transistors de sortie (T5, T6) dont un (T5) est associé avec une section d'entrée (FIG. 3, 4: T1, T3) tandis que l'autre transistor de sortie (T6) est associé avec l'autre section d'entrée (FIG. 3, 4: T2, T4) afin de produire un courant de sortie différentiel (Io+, Io-) qui est une copie d'un courant différentiel (It+, It-) traversant les deuxièmes transistors d'entrée respectives (T3, T4) des sections d'entrées respectives.

5. Amplificateur selon la revendication 4, incluant en outre une résistance (Rt) insérée entre les bornes de transfert des premiers transistors d'entrée respectifs (FIG. 3, 4 :T1, T2) des sections d'entrées respectives.

6. Matrice de commutation (MTX) présentant N entrées de signal (IN1, ..., INN) et P sorties de signal (OUT1, ..., OUTP), dans laquelle chacune des sorties de signal est connectable à chacune des entrées de signal via au moins un trajet de courant incluant au moins un amplificateur (CD) conforme à la revendication 1.

7. Circuit intégré comprenant une matrice de commutation (MTX) selon la revendication 6.

## Claims

1. Amplifier (CD) featuring several transistors, each equipped with a polarisation terminal, a transfer terminal and a reference terminal, wherein the amplifier comprises:
- an input section comprising a first and a second input transistor (Fig. 3, 4: T1, T3) positioned in series between a first and a second power terminal, wherein the transfer terminal of the first input transistor (T1) forms an input (IN+) of the amplifier and is connected to the polarisation terminal of the second input transistor (T3) by a short circuit and is connected to the first power terminal by a resistor (R1), wherein the polarisation terminal of the first input transistor is connected to the reference terminal of the potential (VCC),
- an output section comprising an output transistor (T5) fitted so as to produce an output current (Io+) that is a copy of a current (It+) which passes through the second input transistor (T3).

2. Amplifier according to claim 1, in which the second input transistor (Fig. 3: T3) and the output transistor (T5) form a mirror current.

3. Amplifier according to claim 1, featuring a resistor (R3) inserted between the reference terminal of the first input transistor (Fig. 4: T1) and the transfer terminal of the second input transistor (Fig. 4: T3), wherein the resistor causes a drop in the voltage received by the output transistor (T5) at its polarisation terminal, such that the output current (Io+) varies in function of said drop in voltage.

4. Amplifier according to claim 1, wherein the amplifier comprises a complementary input section (Fig. 3, 4: T2, T4) which has a structure similar to the input section (Fig. 3, 4, T1, T3) defined in claim 1 and forms a pair with it to receive a differential input signal, wherein the output section comprises a pair of output transistors (T5, T6) of which one (T5) is associated to an input section (Fig. 3, 4: T1, T3) whilst the other output transistor (T6) is associated to the other input section (Fig. 3, 4: T2, T4) so as to produce a differential output current (Io+, Io-) that is a copy of a differential current (It+, It-) passing through the second respective input transistors (T3, T4) of the respective input sections.

5. Amplifier according to claim 4, further featuring a resistor (Rt) inserted between the transfer terminals of the respective first input transistors section (Fig. 3, 4: T1, T2) of the respective input sections.

6. Switching fabric (MTX) with N signal inputs (IN1, ..., INN) and P signal outputs (OUT1, ..., OUTP), in which each of the signal outputs may be connected to each of the signal inputs via at least one current path including at least one amplifier (CD) in that is compliant with claim 1.

7. Integrated circuit comprising a switching fabric (MTX) according to claim 6.

## Patentansprüche

1. Verstärker (CD), der mehrere Transistoren enthält, wovon jeder mit einem Vorspannungsanschluss, einem Übertragungsanschluss und einem Referenzanschluss versehen ist, wobei der Verstärker umfasst:
- einen Eingangsabschnitt, der einen ersten und einen zweiten Eingangstransistor (Fig. 3, 4: T1, T3) enthält, die zwischen einem ersten und einem zweiten Versorgungsanschluss in Reihe geschaltet sind, wobei der Übertragungsanschluss des ersten Eingangstransistors (T1) einen Eingang (IN+) des Verstärkers bildet und mit dem Vorspannungsanschluss des zweiten Eingangstransistors (T3) über einen Kurzschluss verbunden ist und mit dem ersten Versorgungsanschluss über einen Widerstand (R1) verbunden ist, wobei der Vorspannungsanschluss des ersten Eingangstransistors mit einem Potential-Referenzanschluss (VCC) verbunden ist,
- einen Ausgangsabschnitt, der einen Ausgangstransistor (T5) enthält, der dazu ausgelegt ist, einen Ausgangsstrom (lo+) zu erzeugen, der eine Kopie eines Stroms (It+) ist, der durch den zweiten Eingangstransistor (T3) fließt.

2. Verstärker nach Anspruch 1, wobei der zweite Eingangstransistor (Fig. 3: T3) und der Ausgangstransistor T5 einen Stromspiegel bilden.

3. Verstärker nach Anspruch 1, der einen Widerstand (R3) enthält, der zwischen den Referenzanschluss des ersten Eingangstransistors (Fig. 4: T1) und den Übertragungsanschluss des zweiten Eingangstransistors (Fig. 4: T3) eingefügt ist, wobei der Widerstand einen Spannungsabfall hervorruft, der von dem Ausgangstransistor (T5) an seinem Vorspannungsanschluss empfangen wird, derart, dass sich der Ausgangsstrom (Io+) als Funktion des Spannungsabfalls verändert.

4. Verstärker nach Anspruch 1, wobei der Verstärker einen komplementären Eingangsabschnitt (Fig. 3, 4: T2, T4) umfasst, der eine ähnliche Struktur wie der Eingangsabschnitt (Fig. 3, 4: T1, T3), der in Anspruch 1 definiert ist, besitzt und mit diesem ein Paar bildet, um ein differentielles Eingangssignal zu empfangen, wobei der Ausgangsabschnitt ein Paar von Ausgangstransistoren (T5, T6) enthält, wovon einem (T5) ein Eingangsabschnitt (Fig. 3, 4: T1, T3) zugeordnet ist, während dem anderen Ausgangstransistor (T6) der andere Eingangsabschnitt (Fig. 3, 4: T2, T4) zugeordnet ist, um einen differentiellen Ausgangsstrom (Io+, Io ) zu erzeugen, der eine Kopie eines differentiellen Stroms (It+, It ) ist, der durch die jeweiligen zweiten Eingangstransistoren (T3, T4) der jeweiligen Eingangsabschnitte fließt.

5. Verstärker nach Anspruch 4, der außerdem einen Widerstand (Rt) enthält, der zwischen die Übertragungsanschlüsse der jeweiligen ersten Eingangstransistoren (Fig. 3, 4: T1, T2) der jeweiligen Eingangsabschnitte eingefügt ist.

6. Koppelmatrix (MTX), die N Signaleingänge (IN1, ..., INN) und P Signalausgänge (OUT1, ..., OUTP) aufweist und in der jeder der Signalausgänge mit jedem der Signaleingänge über wenigstens einen Stromweg verbunden werden kann, der wenigstens einen Verstärker (CD) nach Anspruch 1 enthält.

7. Integrierte Schaltung, die eine Koppelmatrix (MTX) nach Anspruch 6 enthält.
